(19) 

**Europäisches Patentamt**
**European Patent Office**
**Office européen des brevets**

(11) **EP 4 633 040 A1**

(12) # EUROPEAN PATENT APPLICATION

(43) Date of publication:
**15.10.2025 Bulletin 2025/42**

(21) Application number: **24305594.4**

(22) Date of filing: **12.04.2024**

(51) International Patent Classification (IPC):
**H03H 17/02** (2006.01) **H03H 17/06** (2006.01)

(52) Cooperative Patent Classification (CPC):
**H03H 17/0671; H03H 17/023**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **NXP USA, Inc.**
**Austin TX 78735 (US)**

(72) Inventors:
• **d'Esposito, Francesco**
**31023 Toulouse Cedex 1 (FR)**
• **Desposito, Domenico**
**31023 Toulouse Cedex 1 (FR)**
• **Benoit-Cattin, Theo**
**31023 Toulouse Cedex 1 (FR)**

(74) Representative: **Schmütz, Christian Klaus
Johannes
NXP Semiconductors Germany GmbH
Intellectual Property Group
Beiersdorfstr. 12
22529 Hamburg (DE)**

(54) **ELECTRONIC FILTER IMPLEMENTING A SECOND ORDER CASCADED INTEGRATOR COMB FILTER**

(57) An electronic filter comprising: a first coefficient circuit (220) to provide a first coefficient-signal (coeff0) by applying coeff0=2*OSR-1-counter0, where OSR is the oversampling ratio, when a first counter-signal (counter0) >=OSR and applying coeff0=counter0+1, when counter0<0SR. The filter also comprises a first summation circuit (230) to provide a first polarity-signal, polarity0, as either: coeff0 if the ADC bitstream signal is positive; or -coeff0 if the ADC bitstream signal is negative; and integrate polarity0. The filter also comprises a counter modifier circuit (280) to provide a second counter-signal, derived from counter0; a second coefficient circuit (260) to provide a second coefficient-signal; and a second summation circuit (270) to provide a second sub-filter signal. The filter also comprises an output logic circuit (290) to provide a filter output signal to the filter output terminal (213), by switching between providing the first sub-filter signal and the second sub-filter signal as the filter output signal, at the frequency of a clock-signal.

**Fig. 2**

EP 4 633 040 A1

# EP 4 633 040 A1

**Description**

**Field**

The present disclosure relates to an electronic filter, and in particular to a cascaded integrator comb filter.

**Summary**

According to a first aspect of the present disclosure there is provided an electronic filter comprising:

an ADC input terminal for receiving an ADC bitstream signal, wherein a value of the ADC bitstream signal is either 1 or -1;
a counter input terminal for receiving a first counter signal, counter0;
a filter output terminal;
a first coefficient circuit configured to provide a first coefficient signal, coeff0, wherein:

the first coefficient circuit is configured to apply the equation coeff0 = 2*OSR - 1 - counter0, where OSR is an oversampling ratio, when the first counter signal is equal to or above the OSR, to provide the first coefficient signal, and
the first coefficient circuit is configured to apply the equation coeff0 = counter0 + 1, when the first counter signal is below the OSR, to provide the first coefficient signal;

a first summation circuit configured to provide a first sub-filter signal, wherein the first summation circuit comprises a first coefficient application circuit and a first integrator, and wherein:

the first coefficient application circuit is configured to provide a first polarity signal, polarity0, as either: i) coeff0 if the value of the ADC bitstream signal is positive; or ii) -coeff0 if the value of the ADC bitstream signal is negative; and
the first integrator is configured to integrate the first polarity signal to provide the first sub-filter signal;

a counter modifier circuit configured to provide a second counter signal, counter1, wherein the second counter signal is derived from the first counter signal;
a second coefficient circuit configured to provide a second coefficient signal, coeff1, wherein:

the second coefficient circuit is configured to apply the equation coeff1 = 2*OSR - 1 - counter1, when the second counter signal is equal to or above the OSR, to provide the second coefficient signal, and
the second coefficient circuit is configured to apply the equation coeff1 = counter1 + 1, when the second counter signal is below the OSR, to provide the second coefficient signal;

a second summation circuit configured to provide a second sub-filter signal, wherein the second summation circuit comprises a second coefficient application circuit and a second integrator, and wherein:

the second coefficient application circuit is configured to provide a second polarity signal, polarity1, as either: i) coeff1 if the value of the ADC bitstream signal is positive; or ii) -coeff1 if the value of the ADC bitstream signal is negative; and
the second integrator is configured to integrate the second polarity signal to provide the second sub-filter signal;

an output logic circuit configured to provide a filter output signal to the filter output terminal, wherein: the output logic circuit is configured to switch between providing a value of the first sub-filter signal and providing a value of the second sub-filter signal as the filter output signal, at a frequency defined by a clock signal.

Advantageously, such an electronic filter can be implemented with a smaller die size than an equivalent Hogenauer CIC2 filter, without losing any functionality.

In one or more embodiments the first counter signal is configured to incrementally increase in value between zero and 2*OSR - 2.

In one or more embodiments the oversampling ratio is 2048.

In one or more embodiments:

the first coefficient circuit comprises:

2

a first node connected to the counter input terminal for receiving counter0;
a first high counter arithmetic unit comprising: an input terminal connected to the first node, and an output terminal, wherein the first high counter arithmetic unit is configured to apply the equation $coeff0 = 2*OSR - 1 - counter0$;
a first low counter arithmetic unit comprising: an input terminal connected to the first node, and an output terminal, wherein the first low counter arithmetic unit is configured to apply the equation $coeff0 = counter0 + 1$;
a first coefficient selection circuit comprising:

> a first coefficient output terminal,
> a first coefficient control input terminal connected to the first node,
> a first high counter input terminal connected to the output terminal of the first high counter arithmetic unit, and
> a first low counter input terminal connected to the output terminal of the first low counter arithmetic unit.

The first coefficient selection circuit may be configured to connect the first high counter input terminal to the first coefficient output terminal when the first counter signal is equal to or above the OSR, and connect the first low counter input terminal to the first coefficient output terminal when the first counter signal is below the OSR.

The second coefficient circuit may comprise:

> a second node connected to the counter modifier circuit for receiving counter1;
> a second high counter arithmetic unit comprising: an input terminal connected to the second node, and an output terminal, wherein the first high counter arithmetic unit is configured to apply the equation $coeff1 = 2*OSR - 1 - counter1$;
> a second low counter arithmetic unit comprising: an input terminal connected to the second node, and an output terminal, wherein the second low counter arithmetic unit is configured to apply the equation $coeff1 = counter1 + 1$;
> a second coefficient selection circuit comprising:

>> a second coefficient output terminal,
>> a second coefficient control input terminal connected to the second node,
>> a second high counter input terminal connected to the output terminal of the second high counter arithmetic unit, and
>> a second low counter input terminal connected to the output terminal of the second low counter arithmetic unit.

The second coefficient selection circuit may be configured to connect the second high counter input terminal to the second coefficient output terminal when the second counter signal is equal to or above the OSR, and connect the second low counter input terminal to the second coefficient output terminal when the second counter signal is below the OSR.

In one or more embodiments:
the first coefficient application circuit comprises:

> a first coefficient application input terminal connected to the first coefficient output terminal;
> a first coefficient application output terminal;
> a first inverter unit comprising: an input terminal connected to the first coefficient output terminal, and an output terminal, wherein the first inverter unit is configured to multiply the first coefficient signal by -1;
> a first coefficient application selection circuit comprising:

>> a first coefficient application output terminal,
>> a first coefficient application control input terminal configured to receive the ADC bitstream signal;
>> a first high ADC input terminal connected to the first coefficient output terminal;
>> a first low ADC input terminal connected to the output terminal of the first inverter unit.

The first coefficient application selection circuit may be configured to connect the first high ADC input terminal to the first product output terminal when the value of the ADC bitstream signal is positive, and connect the first low ADC input terminal to the first product output terminal when the value of the ADC bitstream signal is negative.

The second coefficient application circuit may comprise:

> a second coefficient application input terminal connected to the second coefficient output terminal;
> a second coefficient application output terminal;
> a second inverter unit comprising: an input terminal connected to the second coefficient output terminal, and an output terminal, wherein the second inverter unit is configured to multiply the second coefficient signal by -1;
> a second coefficient application selection circuit comprising:

a second coefficient application output terminal,
a second coefficient application control input terminal configured to receive the ADC bitstream signal;
a second high ADC input terminal connected to the second coefficient output terminal;
a second low ADC input terminal connected to the output terminal of the second inverter unit.

The second coefficient application selection circuit may be configured to connect the first high ADC input terminal to the second product output terminal when the value of the ADC bitstream signal is positive, and connect the second low ADC input terminal to the first product output terminal when the value of the ADC bitstream signal is negative.

In one or more embodiments:
the first integrator comprises:

a first delay block comprising an input terminal and an output terminal; and
a first addition block comprising a first input terminal, a second input terminal and a first summation output terminal.

The first input terminal of the first addition block may be connected to the first coefficient application circuit,

the second input terminal of the first addition block may be connected to the output terminal of the first delay block, and
the input terminal of the first delay block may be connected to the output of the first addition block.

The second integrator may comprise:

a second delay block comprising an input terminal and an output terminal; and
a second addition block a first input terminal, a second input terminal and a second summation output terminal.

The first input terminal of the second addition block may be connected to the second coefficient application circuit,

the second input terminal of the second addition block may be connected to the output terminal of the second delay block, and
the input terminal of the second delay block may be connected to the output of the second addition block.

In one or more embodiments the counter modifier circuit comprises a phase delay circuit, wherein:
the phase delay circuit is configured to apply the equation counter1 = counter0 - OSR when the first counter signal is equal to or above the OSR to provide the second counter signal, and apply the equation counter1 = counter0 + OSR when the first counter signal is below the OSR, to provide the second counter signal.

In one or more embodiments:
the phase delay circuit comprises:

a phase delay node connected to the counter input terminal;
a phase delay high counter arithmetic unit comprising: an input terminal connected to the phase delay node, and an output terminal, wherein the phase delay high counter arithmetic unit is configured to apply the equation counter1 = counter0 - OSR;
a phase delay low counter arithmetic unit comprising an input terminal connected to the phase delay node and an output terminal, wherein the phase delay low counter arithmetic unit is configured to apply the equation counter1 = counter0 + OSR;
a phase delay selection circuit comprising:

a phase delay output terminal;
a phase delay control input terminal connected to the phase delay node;
a phase delay high counter input terminal connected to the output terminal of the phase delay high counter arithmetic unit, and
a phase delay low counter input terminal connected to the output terminal of the phase delay low counter arithmetic unit.

The phase delay coefficient selection circuit may be configured to connect the phase delay high counter input terminal to the phase delay output terminal when the first counter signal is equal to or above the OSR, and connect the phase delay low counter input terminal to the phase delay output terminal when the first counter signal is below the OSR.

In one or more embodiments the output logic circuit comprises:

a first sub-filter input terminal;
a second sub-filter input terminal;
a first counter input terminal;
a second counter input terminal;
a clock input terminal for receiving the clock signal;
a counter limit input terminal for receiving a counter limit signal;
a first comparator comprising:

a first input terminal connected to the first counter input terminal,
a second input terminal connected to the counter limit input terminal, and
an output terminal for providing a high comparison output signal when the first counter signal is the same as the counter limit signal;

a second comparator comprising:

a first input terminal connected to the second counter input terminal,
a second input terminal connected to the counter limit input terminal, and
an output terminal for providing a high comparison output signal when the second counter signal is the same as the counter limit signal;

a first sub-filter selection circuit comprising:

a first input terminal connected to the first sub-filter input terminal,
a second input terminal,
a first control input terminal connected to the output terminal of the first comparator, and
an output terminal.

The first sub-filter selection circuit may be configured to connect the first input terminal to the output terminal if the first comparator is providing a high comparison output signal, and connect the second input terminal to the output terminal if the first comparator is not providing a high comparison output signal.
The output logic circuit may also comprise:
a second sub-filter selection circuit comprising:

a first input terminal connected to the second sub-filter input terminal,
a second input terminal,
a second control input terminal connected to the output terminal of the second comparator, and
an output terminal connected to the second input terminal of the first sub-filter selection circuit.

The second sub-filter selection circuit may be configured to connect the first input terminal to the output terminal if the second comparator is providing a high comparison output signal, and connect the second input terminal to the output terminal if the second comparator is not providing a high comparison output signal.
The output logic circuit may also include:
a flip flop circuit comprising:

a first clock input connected to the clock input terminal,
a flip flop input terminal connected to the output terminal of the first sub-filter selection circuit, and
a flip flop output terminal connected to the filter output terminal and the second input terminal of the second sub-filter selection circuit. The flip flop circuit may be configured to:

provide a flip flop signal to the flip flop output terminal, and
update the value of the flip flop signal to be equal to a signal provided to the flip flop input terminal at the frequency defined by the clock signal.

In one or more embodiments the filter circuit is a 2nd order cascaded integrator comb filter circuit.
While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

**Brief Description of the Drawings**

One or more embodiments will now be described by way of example only with reference to the accompanying drawings in which:

Fig. 1 shows an example of a cascaded integrator comb filter according to Hogenauer;
Fig. 2 shows an implementation of a second order cascaded integrator comb filter according to an embodiment of this disclosure;
Fig. 3 shows an example coefficient circuit, according to an embodiment of the present disclosure;
Fig. 4 shows an example summation circuit, according to an embodiment of the present disclosure;
Fig. 5 shows an example implementation of a sub-filter, according to an embodiment of the present disclosure;
Fig. 6 shows an example counter modifier circuit, according to an embodiment of the present disclosure;
Fig. 7 shows a plot of the value of the first counter signal and the value of the second counter signal against time; and
Fig. 8 shows an example output logic circuit, according to an embodiment of the present disclosure.

**Detailed Description**

A cascaded integrator comb (CIC) filter can be used for removing interference from a digital signal. For example, a CIC filter can be used to remove interference from a digital signal that is provided by an analogue to digital converter (ADC) in a battery management system, wherein the digital signal represents the battery voltage. When using a CIC filter, a high oversampling ratio (for example 2048) may be used to reduce a quantisation error. The implementation of such filters accounts for an important percentage of the total die area. The embodiments described within the present disclosure present an alternative implementation of a CIC filter which allows for a considerable reduction in die size. The most well-known implementation of a CIC filter in the art is Hogenauer's design.

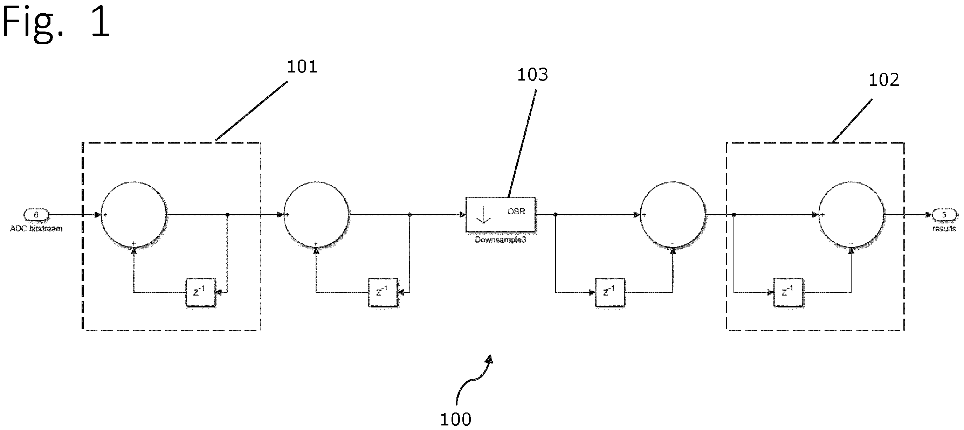

Fig. 1 shows an example of a CIC filter 100 according to Hogenauer. Hogenauer's CIC filter 100 includes one or more integrator stages 101 connected in series, one or more comb stages 102 connected in series, and a down-sampler 103 that is connected in series between the integrator stages 101 and the comb stages 102. A CIC filter has an equal number of integrator stages 101 and comb stages 102, and the order of a CIC filter is defined by the number of integrators stage 101 - comb stage 102 pairs.

The example Hogenauer CIC filter 100 shown in Fig. 1 includes two integrator stages 101 and two comb stages 102 and therefore is a second order CIC filter (CIC2 filter).

The transfer function for Hogenauer's CIC2 filter 100 is:

$$H(z) = \left( \frac{1 - z^{-OSR}}{1 - z^{-1}} \right)^2 \qquad (1)$$

Where *OSR* is the oversampling ratio of the CIC2 filter.

The inventors have identified that the transfer function shown in equation (1) can also be written as:

$$H(z) = \left(\frac{1 - z^{-OSR}}{1 - z^{-1}}\right)^2 = \left[\sum_{k=0}^{OSR-1} z^{-k}\right]^2 = \left(1 + z^{-1} + z^{-2} \dots + z^{-(OSR-1)}\right)^2 =$$

$$= \left(1 + 2 \cdot z^{-1} + \dots + OSR \cdot z^{-(OSR-1)} + (OSR - 1) \cdot z^{-OSR} + (OSR - 2) \cdot z^{-(OSR-1)}\right.$$

$$\left. + \dots + 2 \cdot z^{-(2 \cdot OSR-3)} + z^{-(2 \cdot OSR-2)}\right) =$$

$$= \sum_{k=0}^{2 \cdot OSR-2} c(k) \cdot z^{-k} \qquad\qquad (2)$$

Where:

$$\begin{cases} c(k) = k + 1 & if\ k < OSR \\ c(k) = 2 \cdot OSR - 1 - k & if\ k \geq OSR \end{cases} \qquad (3)$$

Where $c(k)$ is a coefficient. The inventors have found that this alternative form of the transfer function (1) defined by Hogenauer's CIC2 filter 100 can be implemented electronically in a different way to Hogenauer's classic design. By using equation (3), the coefficients $c(k)$ can be derived using a digital counter signal. In the example embodiment that will be described below, the value of the counter signal increases from zero up to $2 \cdot OSR$ - 1, although any suitable means for providing a suitable a counter signal can be used. As will be discussed in detail below, implementing the functionality of Hogenauer's CIC2 filter 100 on the basis of equation (3) can significantly reduce the area that is occupied by the circuit on an integrated circuit. This can be a very significant advantage.

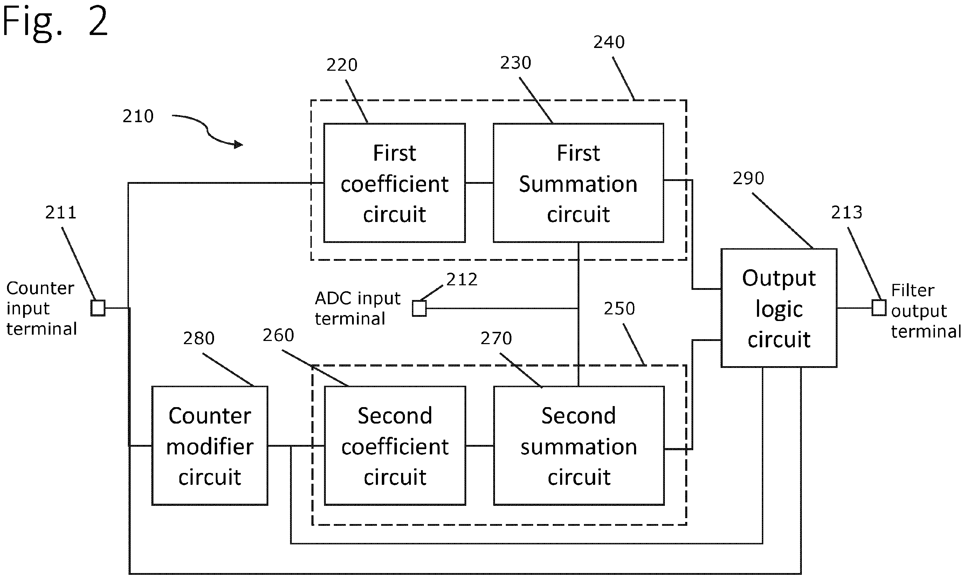

Fig. 2 shows an implementation of a CIC2 filter 210 according to an embodiment of this disclosure. The CIC2 filter 210 provides an electronic implementation of equation (3) and therefore the CIC2 filter 210 behaves in the same way as Hogenauer's CIC2 filter. Beneficially, the CIC2 filter 210 of Figure 2 can be implemented with a smaller die size than an equivalent Hogenauer CIC2 filter, without losing any functionality. For example, a CIC2 filter according to an embodiment of the present disclosure can achieve a reduction in die size of approximately 10-30% when compared to an equivalent Hogenauer CIC2 filter.

The CIC2 filter 210 includes a counter input terminal 211 for receiving a first counter signal, *counter0,* an ADC input terminal 212 for receiving an ADC bitstream signal, wherein the value of the ADC bitstream signal can be +1 or -1, and a filter output terminal 213 for providing a filter output signal. The first counter signal is a digital signal.

The CIC2 filter 210 also includes a first coefficient circuit 220 and a first summation circuit 230, which together can be referred to as a first sub-filter 240.

The first coefficient circuit 220 is configured to provide a first coefficient signal, *coeff0.* The first coefficient circuit is configured to apply the equation *coeff0 = 2\*OSR* - 1 - *counter0,* when the first counter signal is equal to or above the OSR, to provide the first coefficient signal. The first coefficient circuit is configured to apply the equation *coeff0 = counter0 + 1*, when the first counter signal is below the OSR, to provide the first coefficient signal.

The first summation circuit 230 is configured to provide a first sub-filter signal. The first summation circuit 230 includes a first coefficient application circuit and a first integrator, which will be described below. The first coefficient application circuit is configured to provide a first polarity signal, *polarity0,* as either: i) *coeff0* if the value of the ADC bitstream signal is positive (i.e., +1); or ii) *-coeff0* if the value of the ADC bitstream signal is negative (i.e., -1). The first integrator is configured to integrate the value of the first polarity signal to provide the first sub-filter signal.

The CIC2 filter 210 also includes a second sub-filter 250, which has the same components as the first sub-filter 240. However, as will be discussed below, the first and the second sub-filters 240, 250 are provided with different counter signals.

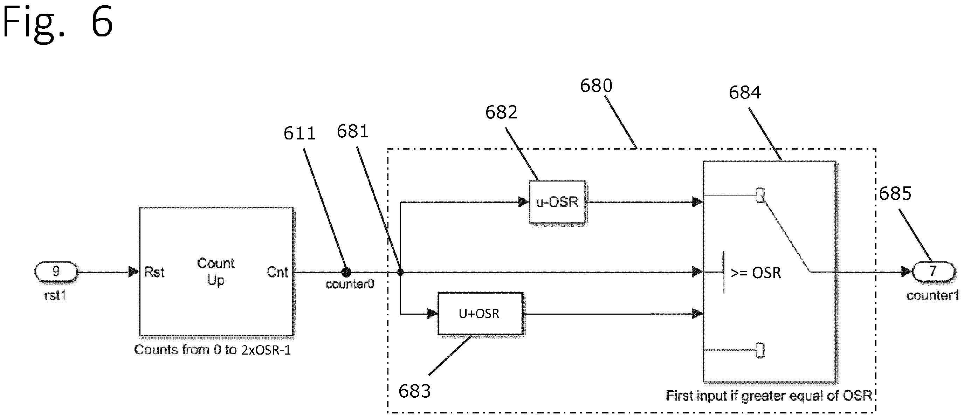

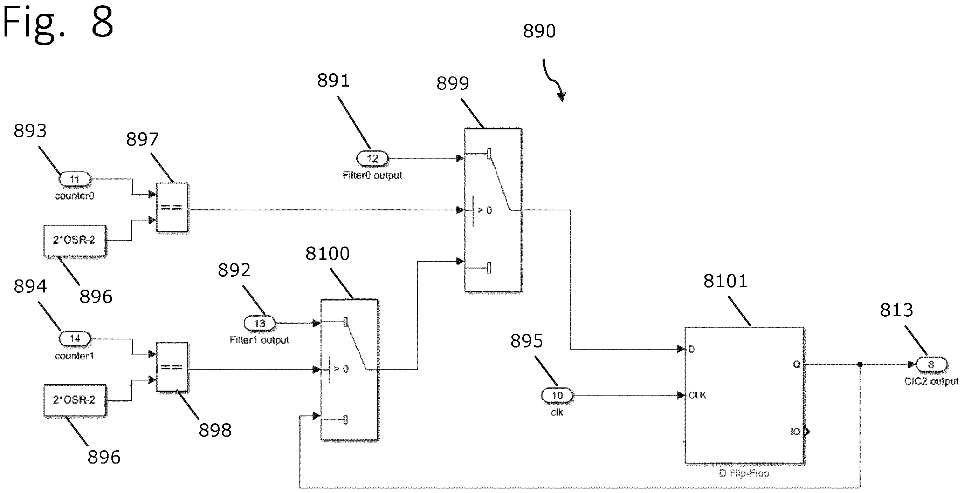

The CIC2 filter 210 provides the filter output signal to the filter output terminal 213 based on output signals from both the first sub-filter 240 and the second sub-filter 250. The manner in which the CIC2 filter 210 uses the output signals from the first sub filter 240 and the second sub-filter 250 will be explained in detail below, with reference to Fig. 8 in particular. By using the first sub-filter 240 and second sub-filter 250, the CIC2 filter 210 is able to be implemented with an even smaller die size, for reasons which will be explained in detail below, with reference to Fig. 6.

The second sub-filter 250 is constructed and operates in the same manner as the first sub-filter 240. The second sub-filter 250 comprises a second coefficient circuit 260 and a second summation circuit 270, each with the same architecture and fulfilling the same role as their equivalents in the first sub-filter 240. However, the second sub-filter 250 differs from the first sub-filter 240 in that the second sub-filter 250 receives and processes a second counter signal, which is derived from the first counter signal in this example. To provide for this, the CIC2 filter 210 also includes a counter modifier circuit 280 that provides a second counter signal, *counter1.* Accordingly, *counter1* is processed into a second coefficient signal, *coeff1,* which is in turn processed into a second polarity signal *polarity1,* which is in turn processed into a second sub-filter signal, which is provided in the same way as the first sub-filter signal.

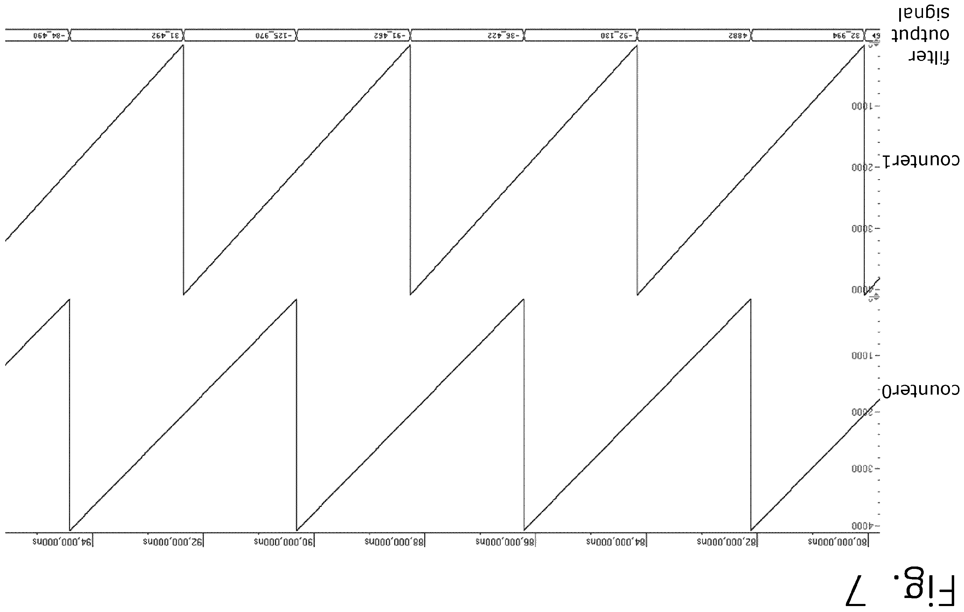

The counter modifier circuit 280 in this example is a phase delay circuit configured to apply the equation *counter1 = counter0 - OSR* when the first counter signal is equal to or above the OSR to provide the second counter signal. The phase delay circuit is configured to apply the equation *counter1 = counter0 + OSR* when the first counter signal is below the OSR, to provide the second counter signal. This results in the counter signals that are shown in Fig. 7, as will be discussed below.

The CIC2 filter 210 also includes an output logic circuit 290 configured to provide the filter output signal. The output logic circuit 290 in this example is configured to switch between providing a value of the first sub-filter signal and providing a value of the second sub-filter signal as the filter output signal, at a frequency defined by a clock signal.

Example embodiments of the electronic configurations of the circuits shown in Fig. 2 will be explained in detail with respect to the following figures.

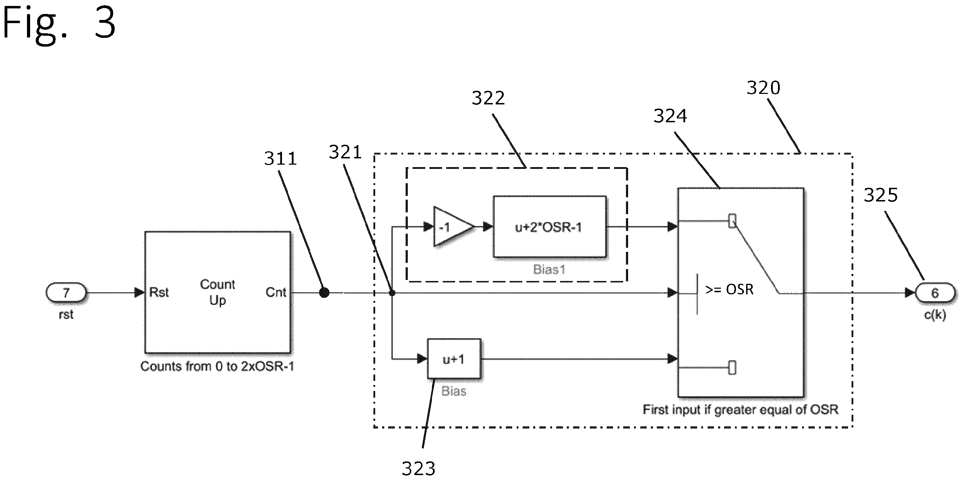

Fig. 3 shows an example coefficient circuit 320, according to an embodiment of the present disclosure. The coefficient circuit 320 of Fig 3. can be used to implement the first and the second coefficient circuits that are shown in Fig. 2. The coefficient circuit 320 provides a coefficient signal by electronically implementing equation (3):

$$\begin{cases} c(k) = k + 1 & if \ k < OSR \\ c(k) = 2 \cdot OSR - 1 - k & if \ k \geq OSR \end{cases} \qquad (3)$$

Where k is the counter signal which is processed by the coefficient circuit 320. That is, k is the first counter signal in the case of the first coefficient circuit and k is the second counter signal in the case of the second coefficient circuit.

As previously mentioned, the first coefficient circuit and the second coefficient circuit of the overall CIC2 filter have equivalent architecture, the only difference being the counter signal received and subsequently processed by each coefficient circuit. The structure of the coefficient circuit 320 of Fig. 3 will only be described in relation to the implementation as the first coefficient circuit.

The coefficient circuit 320 of Fig. 3 includes: a node 321 connected to the counter input terminal for receiving the first counter signal. Fig. 3 shows the node 321 connected to the output terminal of a counter block, wherein the output terminal of the counter block can be considered as the counter input terminal 311 of the electronic filter, which is one example implementation. The first coefficient circuit may be connected to a counter block in this way and the second coefficient circuit may be connected to the counter modifier circuit, which in turn is connected to the counter block.

The coefficient circuit 320 includes a high counter arithmetic unit 322 which includes: an input terminal connected to the node 321, and an output terminal. The high counter arithmetic unit 322 is configured to apply the equation $c(k) = 2 \cdot OSR - 1 - k$ where $k$ is the counter signal. The coefficient circuit 320 includes a low counter arithmetic unit 323 which includes: an input terminal connected to the node 321, and an output terminal. The low counter arithmetic unit 323 is configured to apply the equation $c(k) = k + 1$.

The coefficient circuit 320 also includes a coefficient selection circuit 324 which includes: a coefficient output terminal 325, a coefficient control input terminal connected to the node 321, a high counter input terminal connected to the output terminal of the high counter arithmetic unit 322, and a low counter input terminal connected to the output terminal of the low counter arithmetic unit 323. The coefficient selection circuit 324 is configured to connect the high counter input terminal to the coefficient output terminal when the counter signal $k$ is equal to or above the OSR. The coefficient selection circuit 324 is configured to connect the low counter input terminal to the coefficient output terminal 325 when the counter signal $k$ is below the OSR. The OSR is the oversampling ratio in this example.

In this way, the coefficient circuit 320 provides its respective coefficient signal c(k) to the coefficient output terminal 325 according to equation (3).

Returning to equation (2):

$$= \sum_{k=0}^{2 \cdot OSR - 2} c(k) \cdot z^{-k} \qquad (2)$$

The coefficient c(k) is not the only component of the equation which requires processing to be constructed.

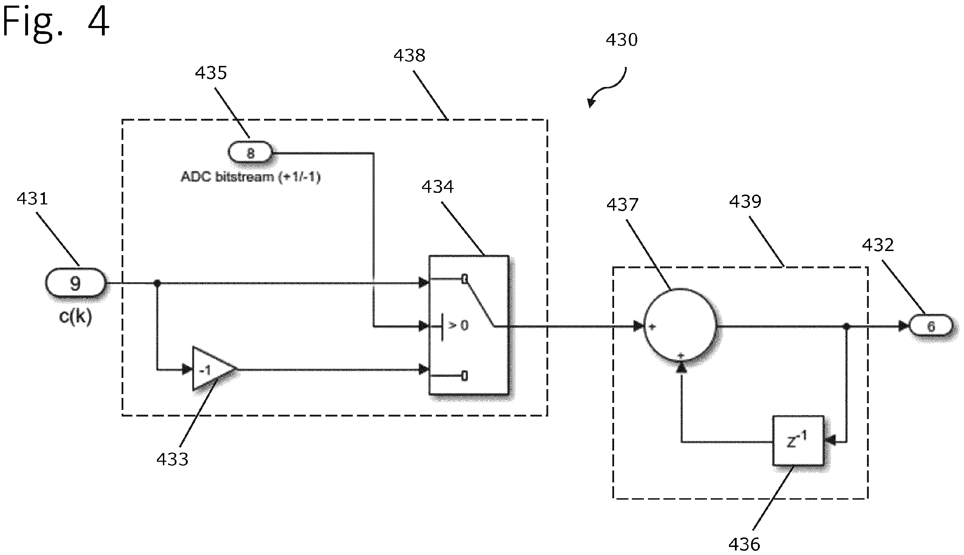

Fig. 4 shows an example summation circuit 430, according to an embodiment of the present disclosure. The summation circuit 430 of Fig. 4 can be used to implement the first and second summation circuits of Fig. 2. The summation circuit 430 provides a sub-filter signal by implementing equation (2). More particularly, the product c(k) $\cdot z^{-k}$ is implemented in Fig. 4 using a multiplexer with a control terminal that receives the ADC bitstream signal. As indicated above, the ADC bitstream signal is a single bit (+1, -1) signal.

Again, the structure of the summation circuit 430 of Fig. 4 will only be described in relation to the first summation circuit of Fig. 2. It will be appreciated that this description also applies to the second summation circuit of Fig. 2.

The summation circuit 430 according to an embodiment of the present disclosure includes: a product input terminal 431 (which is connected to the coefficient output terminal of a coefficient circuit) and a summation output terminal 432. The summation circuit 430 includes a coefficient application circuit 438 and an integrator 439.

The coefficient application circuit 438 includes an inverter unit 433, which includes: an input terminal connected to the product input terminal 431, and an output terminal. The inverter unit 433 is configured to multiply the coefficient signal by *-1*.

The coefficient application circuit 438 also includes a coefficient application selection circuit 434 which includes: a coefficient application output terminal, a coefficient application control input terminal 435 configured to receive the ADC bitstream signal, a high ADC input terminal connected to the coefficient application input terminal 431 and a low ADC input terminal connected to the output terminal of the first inverter unit 433.

The coefficient application circuit 434 is configured to connect the high ADC input terminal to the coefficient application output terminal when the value of the ADC bitstream signal is positive. The coefficient application circuit 434 is configured to connect the low ADC input terminal to the first coefficient application output terminal when the value of the ADC bitstream signal is negative.

In this way, the summation circuit 430 provides its respective polarity signal $c(k) \cdot z^{-k}$ to the coefficient application selection output terminal. The integrator 439 receives and integrates the polarity signal to implement the complete equation (2) in providing a signal to the summation output terminal 432.

The integrator 439 can be implemented using any suitable hardware. In this example embodiment, the integrator 439 includes: a delay block 436 comprising an input terminal and an output terminal, and an addition block 437. The addition block 437 comprises a first input terminal and a second input terminal. The first input terminal of the addition block 437 is connected to the coefficient application selection output terminal, the second input terminal of the addition block 437 is connected to the output terminal of the delay block 436, and the input terminal of the delay block 436 is connected to the output of the addition block 437.

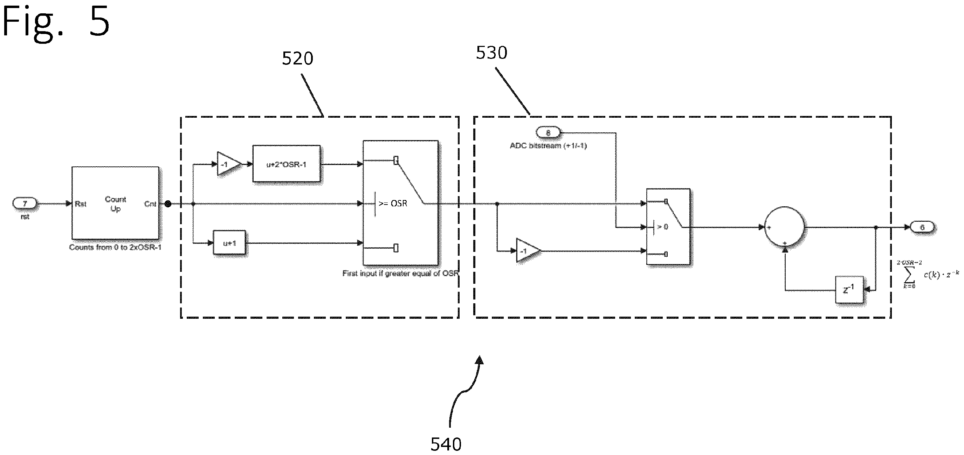

Fig. 5 shows an example implementation of a sub-filter 540, according to an embodiment of the present disclosure. The sub-filter 540 of Fig. 5 shows the coefficient circuit 520 of Fig. 3 connected to the summation circuit 530 of Fig. 4, and therefore is able to provide a processed signal representing the application of equation (2) at its output terminal.

As with the coefficient circuits and the summation circuits of Fig.'s 3 and 4, the sub-filter 540 of Fig. 5. can be used to implement the first and the second sub-filters that are shown in Fig. 2. The sub-filter 540 that is shown in Fig 5 will be described as implementing the functionality of the first sub-filter of Fig. 2.

Fig. 5 shows the sub-filter 540 connected to the output terminal of a counter block, in the same way as Fig. 3.

In order to have a new result of the overall filter provided at the filter output terminal 213 of Fig. 2 each clock cycle, the sub-filter 540 would need to be instantiated 2*OSR times. However, thanks to the decimation of the CIC2 filter that is achieved by application of the oversampling ratio, only one sample for each oversampled clock cycle needs to be generated. This means that the same result can be achieved using just two instances of the sub-filter 540 of Fig. 5. To implement this, the second sub-filter in this example receives a counter signal that is phase delayed with respect to the counter signal that is received by the first sub-filter. In this example, the counter signal, *counter1,* for the second sub-filter is implemented using the equation:

$$\begin{cases} counter_1 = counter_0 + OSR & if\ counter_0 < OSR \quad (4) \\ counter_1 = counter_0 - OSR & if\ counter_0 \geq OSR \end{cases}$$

Beneficially, since only two instances of the sub-filter 540 are required, the die size can be reduced even further.

Fig. 6 shows an example counter modifier circuit, according to an embodiment of the present disclosure. In this embodiment, the counter modifier circuit is a phase delay circuit 680 in that the second counter signal, *counter1,* can be considered as a phase delayed version of the first counter, *counter0.* The phase delay circuit 680 provides an example electronic implementation of equation (4). The phase delay circuit 680 includes: a phase delay node 681 connected to the counter input terminal 611 of the filter circuit (in this example, the counter input terminal 611 is the output terminal of a counter circuit) and a phase delay high counter arithmetic unit 682. The phase delay high counter arithmetic unit 682 comprises: an input terminal connected to the phase delay node 681, and an output terminal. The phase delay high counter arithmetic unit 682 is configured to apply the equation *counter1 = counter0 - OSR.* The phase delay circuit 680 also includes a phase delay low counter arithmetic unit 683 comprising an input terminal connected to the phase delay node 681 and an output terminal. The phase delay low counter arithmetic unit 683 is configured to apply the equation *counter1 =*

*counter0 + OSR.*

The phase delay circuit 680 also includes a phase delay selection circuit 684 which includes: a phase delay output terminal 685; a phase delay control input terminal connected to the phase delay node 681; a phase delay high counter input terminal connected to the output terminal of the phase delay high counter arithmetic unit 682, and a phase delay low counter input terminal connected to the output terminal of the phase delay low counter arithmetic unit 683. The phase delay coefficient selection circuit 684 is configured to connect the phase delay high counter input terminal to the phase delay output terminal 685 when the first counter signal is equal to or above the OSR. The phase delay coefficient selection circuit is configured to connect the phase delay low counter input terminal to the phase delay output terminal 685 when the first counter signal is below the OSR.

Fig. 7 shows a plot of the value of the first counter signal and the value of the second counter signal against time. In this example, the oversampling ratio is 2048. Each counter signal is reset to zero when the value of the counter signal reaches 2*OSR - 1. Due to the phase delay applied by the phase delay circuit, the first counter signal and the second counter signal reach *2*OSR - 1*, and are so reset, alternately and with a regular pattern. In this example, each counter is reset every 4ms, with each reset of the second counter signal occurring 2ms after (and before) a reset of the first counter signal.

As mentioned above, the CIC2 filter includes an output logic circuit which is configured to switch between providing a value of the first sub-filter signal and providing a value of the second sub-filter signal as the filter output signal, at a frequency defined by a clock signal. This is achieved by updating the filter output signal to be equal to the value of each respective sub-filter signal when the corresponding counter signal reaches *2*OSR - 1*. Plotted against the same time axis, the lowest plot in Fig. 7 shows the filter output signal. The value of the filter output signal is updated at each reset of a counter signal, therefore in this example, the value of the filter output signal is reset every 2ms. When the first counter signal is reset, the filter output signal is updated to be equal to the first sub-filter signal and when the second counter signal is reset, the filter output signal is updated to be equal to the second sub-filter signal.

Fig. 8 shows an example output logic circuit 890, according to an embodiment of the present disclosure. The output logic unit 890 includes: a first sub-filter input terminal 891, a second sub-filter input terminal 892, a first counter input terminal 893, a second counter input terminal 894, a clock input terminal 895 for receiving the clock signal and a counter limit input terminal for receiving a counter limit signal 896. In this example, the counter limit signal 896 is equal to *2*OSR - 2*.

The output logic circuit 890 includes a first comparator 897 comprising: a first input terminal connected to the first counter input terminal 893, a second input terminal connected to the counter limit input terminal, and an output terminal for providing a high comparison output signal when the first counter signal is the same as the counter limit signal 896.

The output logic circuit 890 includes a second comparator 898 comprising: a first input terminal connected to the second counter input terminal 894, a second input terminal connected to the counter limit input terminal, and an output terminal for providing a high comparison output signal when the second counter signal is the same as the counter limit signal 896.

The output logic circuit 890 includes a first sub-filter selection circuit 899 comprising: a first input terminal connected to the first sub-filter input terminal 891, a second input terminal, a first control input terminal connected to the output terminal of the first comparator 897, and an output terminal. The first sub-filter selection circuit 899 is configured to connect the first input terminal to the output terminal if the first comparator 897 is providing a high comparison output signal. The first sub-filter selection circuit 899 is configured to connect the second input terminal to the output terminal if the first comparator 897 is not providing a high comparison output signal. In this way, the first sub-filter selection circuit 899 provides an output signal that is equal to the output signal from the first sub-filter when the first counter signal, *counter0,* equals its maximum value before it is reset. For the rest of the time, the first sub-filter selection circuit 899 provides an output signal that is equal to the signal that it receives at its second input terminal.

The output logic circuit 890 also includes a second sub-filter selection circuit 8100 comprising: a first input terminal connected to the second sub-filter input terminal 892, a second input terminal, a second control input terminal connected to the output terminal of the second comparator 898, and an output terminal connected to the second input terminal of the first sub-filter selection circuit 899. The second sub-filter selection circuit 8100 is configured to connect the first input terminal to the output terminal if the second comparator 898 is providing a high comparison output signal. The second sub-filter selection circuit 8100 is configured to connect the second input terminal to the output terminal if the second comparator 898 is not providing a high comparison output signal. In this way, the second sub-filter selection circuit 8100 provides an output signal that is equal to the output signal from the second sub-filter when the second counter signal, *counter1,* equals its maximum value before it is reset. For the rest of the time, the second sub-filter selection circuit 8100 provides an output signal that is equal to the signal that it receives at its second input terminal.

The output logic circuit 890 also includes a D-type flip flop circuit 8101 comprising: a first clock input terminal (CLK) connected to the clock input terminal 895, a data input terminal (D) connected to the output terminal of the first sub-filter selection circuit 899, and a flip flop output terminal (Q) connected to the filter output terminal 813. The flip flop output terminal (Q) is also connected to the second input terminal of the second sub-filter selection circuit 8100. As is known in the art, the D-type flip flop circuit 8101 provides the signal that is received at its data input terminal (D) to the flip flop output terminal (Q) in response to an edge in the clock signal that is received at the first clock input terminal (CLK) 895.

In this way, the flip flop output terminal (Q) of the D-type flip flop circuit 8101 is connected to its data input terminal (D), via the second sub-filter selection circuit 8100 and the first sub-filter selection circuit 899, at all times apart from when either: i) the first counter signal, *counter0,* equals its maximum value before it is reset; and ii) the second counter signal, *counter1,* equals its maximum value before it is reset. Therefore, apart at all these other times, the signal at the flip flop output terminal (Q) of the D-type flip flop circuit 8101 does not change.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

**Claims**

1. An electronic filter comprising:

   an ADC input terminal for receiving an ADC bitstream signal, wherein a value of the ADC bitstream signal is either 1 or -1;
   a counter input terminal for receiving a first counter signal, counter0;
   a filter output terminal;
   a first coefficient circuit configured to provide a first coefficient signal, coeff0, wherein:

      the first coefficient circuit is configured to apply the equation coeff0 = 2*OSR - 1 - counter0, where OSR is an oversampling ratio, when the first counter signal is equal to or above the OSR, to provide the first coefficient signal, and
      the first coefficient circuit is configured to apply the equation coeff0 = counter0 + 1, when the first counter signal is below the OSR, to provide the first coefficient signal;

   a first summation circuit configured to provide a first sub-filter signal, wherein the first summation circuit comprises a first coefficient application circuit and a first integrator, and wherein:

the first coefficient application circuit is configured to provide a first polarity signal, polarity0, as either: i) coeff0 if the value of the ADC bitstream signal is positive; or ii) -coeff0 if the value of the ADC bitstream signal is negative; and

the first integrator is configured to integrate the first polarity signal to provide the first sub-filter signal;

a counter modifier circuit configured to provide a second counter signal, counter1, wherein the second counter signal is derived from the first counter signal;

a second coefficient circuit configured to provide a second coefficient signal, coeff1, wherein:

the second coefficient circuit is configured to apply the equation coeff1 = 2*OSR - 1 - counter1, when the second counter signal is equal to or above the OSR, to provide the second coefficient signal, and

the second coefficient circuit is configured to apply the equation coeff1 = counter1 + 1, when the second counter signal is below the OSR, to provide the second coefficient signal;

a second summation circuit configured to provide a second sub-filter signal, wherein the second summation circuit comprises a second coefficient application circuit and a second integrator, and wherein:

the second coefficient application circuit is configured to provide a second polarity signal, polarity1, as either: i) coeff1 if the value of the ADC bitstream signal is positive; or ii) -coeff1 if the value of the ADC bitstream signal is negative; and

the second integrator is configured to integrate the second polarity signal to provide the second sub-filter signal;

an output logic circuit configured to provide a filter output signal to the filter output terminal, wherein: the output logic circuit is configured to switch between providing a value of the first sub-filter signal and providing a value of the second sub-filter signal as the filter output signal, at a frequency defined by a clock signal.

2. The electronic filter of claim 1, wherein the first counter signal is configured to incrementally increase in value between zero and 2*OSR - 2.

3. The filter circuit of any preceding claim, wherein the oversampling ratio is 2048.

4. The electronic filter of any preceding claim, wherein:

the first coefficient circuit comprises:

a first node connected to the counter input terminal for receiving counter0;
a first high counter arithmetic unit comprising: an input terminal connected to the first node, and an output terminal, wherein the first high counter arithmetic unit is configured to apply the equation coeff0 = 2*OSR - 1 - counter0;
a first low counter arithmetic unit comprising: an input terminal connected to the first node, and an output terminal, wherein the first low counter arithmetic unit is configured to apply the equation coeff0 = counter0 + 1;
a first coefficient selection circuit comprising:

a first coefficient output terminal,
a first coefficient control input terminal connected to the first node,
a first high counter input terminal connected to the output terminal of the first high counter arithmetic unit, and
a first low counter input terminal connected to the output terminal of the first low counter arithmetic unit, wherein:

the first coefficient selection circuit is configured to connect the first high counter input terminal to the first coefficient output terminal when the first counter signal is equal to or above the OSR, and
the first coefficient selection circuit is configured to connect the first low counter input terminal to the first coefficient output terminal when the first counter signal is below the OSR; and

the second coefficient circuit comprises:

a second node connected to the counter modifier circuit for receiving counter1;

a second high counter arithmetic unit comprising: an input terminal connected to the second node, and an output terminal, wherein the first high counter arithmetic unit is configured to apply the equation coeff1 = 2*OSR - 1 - counter1;

a second low counter arithmetic unit comprising: an input terminal connected to the second node, and an output terminal, wherein the second low counter arithmetic unit is configured to apply the equation coeff1 = counter1 + 1;

a second coefficient selection circuit comprising:

> a second coefficient output terminal,
> a second coefficient control input terminal connected to the second node,
> a second high counter input terminal connected to the output terminal of the second high counter arithmetic unit, and
> a second low counter input terminal connected to the output terminal of the second low counter arithmetic unit, wherein:
>
> > the second coefficient selection circuit is configured to connect the second high counter input terminal to the second coefficient output terminal when the second counter signal is equal to or above the OSR, and
> > the second coefficient selection circuit is configured to connect the second low counter input terminal to the second coefficient output terminal when the second counter signal is below the OSR.

5. The electronic filter of any preceding claim, wherein:

the first coefficient application circuit comprises:

> a first coefficient application input terminal connected to the first coefficient output terminal;
> a first coefficient application output terminal;
> a first inverter unit comprising: an input terminal connected to the first coefficient output terminal, and an output terminal, wherein the first inverter unit is configured to multiply the first coefficient signal by -1;
> a first coefficient application selection circuit comprising:
>
> > a first coefficient application output terminal,
> > a first coefficient application control input terminal configured to receive the ADC bitstream signal;
> > a first high ADC input terminal connected to the first coefficient output terminal;
> > a first low ADC input terminal connected to the output terminal of the first inverter unit; wherein:
> >
> > > the first coefficient application selection circuit is configured to connect the first high ADC input terminal to the first product output terminal when the value of the ADC bitstream signal is positive, and
> > > the first coefficient application selection circuit is configured to connect the first low ADC input terminal to the first product output terminal when the value of the ADC bitstream signal is negative; and

the second coefficient application circuit comprises:

> a second coefficient application input terminal connected to the second coefficient output terminal;
> a second coefficient application output terminal;
> a second inverter unit comprising: an input terminal connected to the second coefficient output terminal, and an output terminal, wherein the second inverter unit is configured to multiply the second coefficient signal by -1;
> a second coefficient application selection circuit comprising:
>
> > a second coefficient application output terminal,
> > a second coefficient application control input terminal configured to receive the ADC bitstream signal;
> > a second high ADC input terminal connected to the second coefficient output terminal;
> > a second low ADC input terminal connected to the output terminal of the second inverter unit; wherein:

the second coefficient application selection circuit is configured to connect the first high ADC input terminal to the second product output terminal when the value of the ADC bitstream signal is positive, and

the second coefficient application selection circuit is configured to connect the second low ADC input terminal to the first product output terminal when the value of the ADC bitstream signal is negative.

6. The filter circuit of any preceding claim, wherein

the first integrator comprises:

a first delay block comprising an input terminal and an output terminal; and
a first addition block comprising a first input terminal, a second input terminal and a first summation output terminal, wherein:

the first input terminal of the first addition block is connected to the first coefficient application circuit,
the second input terminal of the first addition block is connected to the output terminal of the first delay block, and
the input terminal of the first delay block is connected to the output of the first addition block; and

the second integrator comprises:

a second delay block comprising an input terminal and an output terminal; and
a second addition block a first input terminal, a second input terminal and a second summation output terminal, wherein:

the first input terminal of the second addition block is connected to the second coefficient application circuit,
the second input terminal of the second addition block is connected to the output terminal of the second delay block, and
the input terminal of the second delay block is connected to the output of the second addition block.

7. The electronic filter of any preceding claim, wherein the counter modifier circuit comprises a phase delay circuit, wherein:

the phase delay circuit is configured to apply the equation counter1 = counter0 - OSR when the first counter signal is equal to or above the OSR to provide the second counter signal, and
the phase delay circuit is configured to apply the equation counter1 = counter0 + OSR when the first counter signal is below the OSR, to provide the second counter signal.

8. The filter circuit of claim 7, wherein
the phase delay circuit comprises:

a phase delay node connected to the counter input terminal;
a phase delay high counter arithmetic unit comprising: an input terminal connected to the phase delay node, and an output terminal, wherein the phase delay high counter arithmetic unit is configured to apply the equation counter1 = counter0 - OSR;
a phase delay low counter arithmetic unit comprising an input terminal connected to the phase delay node and an output terminal, wherein the phase delay low counter arithmetic unit is configured to apply the equation counter1 = counter0 + OSR;
a phase delay selection circuit comprising:

a phase delay output terminal;
a phase delay control input terminal connected to the phase delay node;
a phase delay high counter input terminal connected to the output terminal of the phase delay high counter arithmetic unit, and
a phase delay low counter input terminal connected to the output terminal of the phase delay low counter arithmetic unit, wherein:

the phase delay coefficient selection circuit is configured to connect the phase delay high counter input terminal to the phase delay output terminal when the first counter signal is equal to or above the OSR, and the phase delay coefficient selection circuit is configured to connect the phase delay low counter input terminal to the phase delay output terminal when the first counter signal is below the OSR.

9. The filter circuit of any preceding claim, wherein the output logic circuit comprises:

a first sub-filter input terminal;
a second sub-filter input terminal;
a first counter input terminal;
a second counter input terminal;
a clock input terminal for receiving the clock signal;
a counter limit input terminal for receiving a counter limit signal;
a first comparator comprising:

a first input terminal connected to the first counter input terminal,
a second input terminal connected to the counter limit input terminal, and
an output terminal for providing a high comparison output signal when the first counter signal is the same as the counter limit signal;

a second comparator comprising:

a first input terminal connected to the second counter input terminal,
a second input terminal connected to the counter limit input terminal, and
an output terminal for providing a high comparison output signal when the second counter signal is the same as the counter limit signal;

a first sub-filter selection circuit comprising:

a first input terminal connected to the first sub-filter input terminal,
a second input terminal,
a first control input terminal connected to the output terminal of the first comparator, and
an output terminal, wherein:

the first sub-filter selection circuit is configured to connect the first input terminal to the output terminal if the first comparator is providing a high comparison output signal, and
the first sub-filter selection circuit is configured to connect the second input terminal to the output terminal if the first comparator is not providing a high comparison output signal;

a second sub-filter selection circuit comprising:

a first input terminal connected to the second sub-filter input terminal,
a second input terminal,
a second control input terminal connected to the output terminal of the second comparator, and
an output terminal connected to the second input terminal of the first sub-filter selection circuit, wherein:

the second sub-filter selection circuit is configured to connect the first input terminal to the output terminal if the second comparator is providing a high comparison output signal, and
the second sub-filter selection circuit is configured to connect the second input terminal to the output terminal if the second comparator is not providing a high comparison output signal;

a flip flop circuit comprising:

a first clock input connected to the clock input terminal,
a flip flop input terminal connected to the output terminal of the first sub-filter selection circuit, and
a flip flop output terminal connected to the filter output terminal and the second input terminal of the second sub-filter selection circuit, wherein the flip flop circuit is configured to:

provide a flip flop signal to the flip flop output terminal, and
update the value of the flip flop signal to be equal to a signal provided to the flip flop input terminal at the frequency defined by the clock signal.

10. The filter circuit of any preceding claim, wherein the filter circuit is a $2^{nd}$ order cascaded integrator comb filter circuit.

Fig. 1

# Fig. 2

EP 4 633 040 A1

Fig. 3

Fig. 4

Fig. 5

Fig. 6

# Fig. 7

EP 4 633 040 A1

Fig. 8

**EUROPEAN SEARCH REPORT**

Application Number

EP 24 30 5594

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KR 101 878 651 B1 (INNOWIRELESS CO LTD [KR]) 16 July 2018 (2018-07-16) * page 2 * ----- | 1-10 | INV. H03H17/02 H03H17/06 |
| A | GAO Y ET AL: "AN IMPROVED ARCHITECTURE AND IMPLEMENTATION OF CASCADED INTEGRATOR-COMB DECIMATION FILTERS", 1999 IEEE PACIFIC RIM CONFERENCE ON COMMUNICATIONS, COMPUTERS AND SIGNAL PROCESSING. VICTORIA, BC, AUG. 22 - 24, 1999; [IEEE PACIFIC RIM CONFERENCE ON COMMUNICATIONS, COMPUTERS AND SIGNAL PROCESSING. PACRIM], NEW YORK, NY, IEEE, US, vol. CONF. 7, no. CONF. 07, 22 August 1999 (1999-08-22), pages 317-320, XP000898956, ISBN: 978-0-7803-5583-5 * figure 4 * ----- | 1-10 | |
| A | WO 2016/021382 A1 (AZBIL CORP [JP]) 11 February 2016 (2016-02-11) * figures 4-10 * ----- | 1-10 | TECHNICAL FIELDS SEARCHED (IPC) H03H |

The present search report has been drawn up for all claims

| Place of search | Date of completion of the search | Examiner |
|---|---|---|
| Munich | 8 October 2024 | Naumann, Olaf |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 30 5594

This annex lists the patent family members relating to the patent documents cited in the above-mentioned European search report.
The members are as contained in the European Patent Office EDP file on
The European Patent Office is in no way liable for these particulars which are merely given for the purpose of information.

08-10-2024

| Patent document cited in search report | Publication date | Patent family member(s) | | Publication date |
|---|---|---|---|---|
| KR 101878651 B1 | 16-07-2018 | NONE | | |
| WO 2016021382 A1 | 11-02-2016 | CN | 106575959 A | 19-04-2017 |
| | | JP | 6333390 B2 | 30-05-2018 |
| | | JP WO2016021382 A1 | | 25-05-2017 |
| | | US | 2017222627 A1 | 03-08-2017 |
| | | WO | 2016021382 A1 | 11-02-2016 |

For more details about this annex : see Official Journal of the European Patent Office, No. 12/82